# EUROPÄISCHE PATENTANMELDUNG

(11) **EP 3 767 829 A1**
(43) Veröffentlichungstag der Anmeldung: **20.01.2021**
(21) Anmeldenummer: 20174056.0
(22) Anmeldetag: 12.05.2020
(51) Int. Cl.: H03H 7/40

(54) **ANORDNUNG ZUR AUTOMATISCHEN IMPEDANZANPASSUNG**

(30) Priorität: 16.07.2019 DE 102019119177
(71) Anmelder: Technische Universität Dresden, 01069 Dresden (DE)
(72) Erfinder: Laabs, Martin, 01097 Dresden (DE); Dr. Wang, Qiong, 01237 Dresden (DE); Prof. Plettemeier, Dirk, 01187 Dresden (DE); Ramzan, Mehrab, 01069 Dresden (DE)
(74) Vertreter: Sperling, Thomas

(57) **Zusammenfassung**

Der Erfindung, welche eine Anordnung (1) zur Impedanzanpassung betrifft, liegt die Aufgabe zugrunde, eine Anordnung (1) anzugeben, welche eine Anpassung einer Impedanz einer Last (6), wie beispielsweise einer Antenne, an eine Signalquelle (5), wie beispielsweise ein Hochfrequenzverstärker, unter Verringerung des Bauteilaufwands, des benötigten Bauraums und der Kosten ermöglicht. Dazu wird ein adaptives Anpassnetzwerk (2) , welches mit einem Eingang (3) mit einer Signalquelle (5) verbunden ist, welches mit einem Ausgang (4) mit einer Antenne (6) verbunden ist und welches mit einer Kontrolleinheit (7) zur Steuerung des adaptiven Anpassnetzwerks (2) verbunden ist vorgesehen. Desweiteren ist ein erster Leistungsdetektor (8) zwischen dem Eingang (3) und der Kontrolleinheit (7) und ein zweiter Leistungsdetektor (9) zwischen dem Ausgang (4) und der Kontrolleinheit (7) angeordnet ist.

## Beschreibung

Die Erfindung betrifft eine Anordnung zur Impedanzanpassung, welche ein adaptives Anpassnetzwerk umfasst, welches mit einem Eingang mit einer Signalquelle verbunden ist, welches mit einem Ausgang mit einer Antenne verbunden ist und welches mit einer Kontrolleinheit zur Steuerung des adaptiven Anpassnetzwerks verbunden ist.

Bei einigen Anwendungen im Bereich der Hochfrequenztechnik ändert sich die Impedanz einer Baugruppe, wie beispielsweise einer Antenne eines Mobiltelefons, durch äußere Einflüsse. Diese Einflüsse können eine Änderung der Lage des Mobiltelefons und somit dessen Antenne, eine Änderung des Abstands der Antenne zu Gegenständen oder Personen und andere mehr sein. Hierbei sind Gegenstände oder Personen gemeint, welche der Antenne so nahekommen, dass diese die Sende- und Empfangseigenschaften der Antenne beeinflussen.

Der Begriff der Impedanz, welcher auch als Wechselstromwiderstand bekannt ist, ist ein elektrischer Widerstand in der Wechselstromtechnik. Diese Impedanz gibt für ein zweipoliges Netzwerkelement das Verhältnis einer elektrischen Spannung zu einer Stromstärke an, insbesondere dann, wenn zwischen beiden Größen eine sogenannte Phasenverschiebung besteht. Somit unterscheidet sich eine derartige Impedanz grundsätzlich von einem Widerstand in Gleichstromanwendungen. Die Impedanz ist somit eine physikalische Größe zur Beschreibung der Parameter bzw. Eigenschaft eines Bauelementes oder einer Baugruppe, allgemein auch als passiver linearer Zweipol bezeichnet, in einem Wechselstrom kreis.

Bei Anwendungen im Bereich der Hochfrequenztechnik ist es üblich, dass entsprechende Hochfrequenz-Baugruppen ihre maximale Leistung bei einer angepassten Impedanz, beispielsweise zwischen einer Sendebaugruppe und einer angeschlossenen Antenne, erreichen bzw. übertragen.

Unter dem Begriff einer angepassten Impedanz wird auch eine Impedanzanpassung bzw. Leistungsanpassung verstanden, bei welcher ein Ausgangswiderstand einer hochfrequenten Signalquelle optimal an den Eingangswiderstand einer angeschlossenen Last angepasst ist. Hierbei ist mit einer optimalen Anpassung eine Übereinstimmung der Größe bzw. der Werte des konjugiert komplexen Ausgangswiderstands und des konjugiert komplexen Eingangswiderstands gemeint.

Bei einer derartigen angepassten Impedanz wird somit die maximale Leistung bei einer Signalübertragung erreicht, wobei bei einer Abweichung von dieser angepassten Impedanz immer mit einer reduzierten Leistung bei der Signalübertragung zu rechnen ist.

Am Beispiel eines Mobiltelefons führt eine Änderung der Antennenimpedanz zu einer üblicherweise reduzierten, abgestrahlten Leistung und somit meist zu einer geringeren Effizienz bei der Datenübertragung des Mobiltelefons.

Bekannt ist es auch, Implantate in Körpern von Lebewesen anzuordnen, welche über eine Sendeeinheit oder eine Sende- und Empfangseinheit verfügen und beispielsweise aufgezeichnete Messdaten aus dem Körper an eine externe Einheit drahtlos übermitteln. Derartige Implantate können beispielsweise ein Herzschrittmacher oder andere drahtlos Daten übertragende Kapseln sein. Derartige Implantate können sowohl nahe der Oberfläche oder tief im Körper angeordnet sein.

Je nach Position des Implantats im Körper wird die Antenne des Implantats unterschiedlich beeinflusst, wobei sich unterschiedliche Impedanzen einstellen, welche die Güter der Signalübertragung beeinflussen. Somit besteht auch in diesem medizinischen Bereich eine Notwendigkeit Abweichungen von einer angepassten Impedanz zu erkennen und zu beseitigen.

Bekannt ist es, mittels sogenannter Anpassnetzwerke die Impedanz einer Baugruppe an vorhandene Gegebenheiten anzupassen. Derart ist es möglich, die Impedanz der Baugruppe wie beispielsweise einer Hochfrequenz-Signalquelle bzw. eines Hochfrequenzverstärkers an die Impedanz einer angeschlossenen Baugruppe wie einer Antenne anzupassen. Zu diesem Zweck wird das Anpassnetzwerk zwischen der Hochfrequenz-Signalquelle und der Antenne angeordnet.

Für den Fall, dass die Impedanz des Anpassnetzwerks während des Betriebs verändert werden kann, spricht man von einem adaptiven, variablen bzw. steuerbaren Anpassnetzwerk. Eine derartige Veränderung der Impedanz kann beispielsweise elektrisch erfolgen.

Derartige adaptive, variable bzw. steuerbare Anpassnetzwerke, nachfolgend nur noch als adaptives Anpassnetzwerk bezeichnet, weisen beispielsweise in einem Längszweig und einem Querzweig des Anpassnetzwerks Bauelemente wie Induktivitäten und Kapazitäten auf, welche veränderbar sind. Eine Veränderung der Werte dieser Induktivitäten und Kapazitäten kann beispielsweise elektrisch erfolgen, indem an das adaptive Anpassnetzwerk ein entsprechendes analoges oder digitales Steuersignal angelegt wird. Durch verschiedene Größen bzw. Werte des Steuersignals kann das adaptive Anpassnetzwerk in verschiedene Schaltzustände versetzt werden, wobei sich seine Eigenschaft wie seine Ein- und Ausgangsimpedanz bzw. seine Übertragungsfunktion verändert.

Wird dieses adaptive bzw. steuerbare Anpassnetzwerk zusätzlich durch eine Kontrolleinheit und eine Messvorrichtung, welche eine Impedanzmessung ermöglicht, erweitert, so ist es möglich eine aktuelle Impedanzmessung mittels der Messeinrichtung durchzuführen und die aktuellen Messwerte an die Kontrolleinheit zu übertragen. Die Kontrolleinheit erzeugt auf der Grundlage der Messwerte ein Steuersignal, mittels dessen es möglich ist das adaptive bzw. steuerbare Anpassnetzwerk zu regeln und dessen Impedanz entsprechend zu verändern. Eine derartige Regelung kann solange fortgesetzt werden, bis die durch die Messeinrichtung erzeugten aktuellen Messwerte einen Wert erreichen, welcher beispielsweise innerhalb eines vorgegebenen Toleranzbereichs liegen.

Derart ist es möglich, eine nahezu optimale Anpassung der Impedanz einer Baugruppe wie beispielsweise einer Hochfrequenz-Signalquelle an eine angeschlossene Baugruppe wie eine Antenne zu erreichen. Derart ist es auch möglich, die Impedanz an sich verändernde Umgebungsbedingungen, welche beispielsweise einen Einfluss auf die Antenne ausüben, aktuell anzupassen.

Aus dem Stand der Technik sind Systeme bekannt, welche getrennte Baugruppen zur Messung der Impedanz und zur Transformation zur optimalen Impedanz, beispielsweise in einem adaptiven Anpassnetzwerk, nutzen. Nach einer Bestimmung der Impedanz mittels einer entsprechenden Messeinrichtung wird das adaptive Anpassnetzwerk durch das Steuersignal auf die richtigen Transformationskoeffizienten eingestellt und derart eine Impedanzanpassung vorgenommen.

Als Baugruppen zur Messung der Impedanz kommen nach dem Stand der Technik sogenannte Richtkoppler oder sogenannte komplexe Serienelemente mit Abgriffen für die Signale in Verbindung mit Amplituden- und/oder Phasendetektoren zum Einsatz. Alternativ können auch Vektorvoltmeter, welche einen Amplituden- und einen Phasendetektor aufweisen, eingesetzt werden.

In einer auch aus dem Stand der Technik bekannten Alternative besteht ein reduzierter Ansatz darin, dass die mit dem Richtkoppler verbundenen Amplituden- und Phasendetektoren durch Leistungsdetektoren ersetzt werden. Mittels einer derartigen Messanordnung lässt sich das sogenannte Stehwellenverhältnis (VSWR; englisch: voltage standing wave ratio) bestimmen. Da dieses Stehwellenverhältnis aber keine eindeutige Zuordnung zu der Antennenimpedanz mehr zulässt, muss das Anpassnetzwerk durch zusätzliche Optimierungsalgorithmen in mehreren Schritten auf ein Minimum bzw. ein lokales Minimum der Anpassverluste hin optimiert werden.

Derartiger Stand der Technik ist beispielsweise in "Adaptive RF Front-Ends for Hand-held Applications" von Andre van Bezooijen, Reza Mahmoudi, Arthur im Kapitel 3 sowie in "Closed-Ioop Adaptive Control Techniques for Matching Networks in the Uplink Mode" von Amir Danak, Shirook M.H. Ali, James Warden, Mark Pecen, IEEE, Date of Conference: 6-10 Oct. 2013 beschrieben.

Ein Nachteil dieses bekannten Standes der Technik besteht darin, dass diese Lösungen Detektoren benötigen, welche das Signal nach Phase und Amplitude auswerten können. Derartige Detektoren sind aufwendig und haben einen relativ hohen Leistungsbedarf.

Ein weiterer Nachteil besteht darin, dass ein Richtkoppler oder ein Serienelement benötigt wird. Außerdem ist es notwendig, dass das Serienelement für eine ausreichend gute Messgenauigkeit auf einen bestimmten zu erwartenden Impedanzbereich dimensioniert werden muss.

Zudem können derartige Lösungen nur die Impedanz der anzupassenden Last bestimmen.

Wird ein Verfahren unter Nutzung von Stehwellenverhältnissen (VSWR-Methode) verwendet, ist durch die Notwendigkeit der iterativen Optimierung ein Mehrfaches nicht deterministisches Einstellen des Anpassnetzwerks notwendig. Zudem besteht bei derartigen Verfahren die Gefahr, dass die Optimierung nur ein lokales Minimum der Anpassung findet.

Auf der Grundlage dieses Standes der Technik besteht ein Bedarf nach einer verbesserten Anordnung zur Impedanzanpassung.

Die Aufgabe der Erfindung besteht nunmehr darin, eine Anordnung zur Impedanzanpassung anzugeben, welche eine Anpassung einer Impedanz einer Last, wie beispielsweise einer Antenne, an eine Signalquelle, wie beispielsweise ein Hochfrequenzverstärker, unter Verringerung des Bauteilaufwands, des benötigten Bauraums und der Kosten ermöglicht.

Außerdem soll die Anpassung einer Impedanz in Echtzeit, das heißt in einer deterministischen Zeitdauer, erfolgen.

Die Aufgabe wird durch eine Anordnung mit den Merkmalen gemäß Patentanspruch 1 der selbstständigen Patentansprüche gelöst. Weiterbildungen sind in den abhängigen Patentansprüchen angegeben.

Vorgesehen ist es, dass gemäß der Erfindung ein adaptives Anpassnetzwerk mit seinem Eingang mit einer Signalquelle und mit seinem Ausgang mit einer Last verschaltet ist. Hierbei kann die Signalquelle beispielsweise als ein Hochfrequenzverstärker und die Last als eine Antenne ausgeführt sein.

Gemäß der vorliegenden Erfindung ist es weiterhin vorgesehen, dass am Eingang und am Ausgang des adaptiven Anpassnetzwerks, also vor und hinter dem adaptiven Anpassnetzwerk, in einer Signalübertragungsrichtung gesehen, jeweils eine Bestimmung einer Amplitude bzw. einer Leistung des am Eingang und am Ausgang anliegenden Hochfrequenzsignals erfolgt.

Vorgesehen ist es hierfür, dass jeweils ein Teil des Signals mittels Koppelkondensatoren aus dem Signalweg ausgekoppelt wird und dass das ausgekoppelte Signal in eine der Leistung proportionale Gleichspannung oder einen Gleichstrom umgewandelt wird. Zu diesem Zweck können beispielsweise Schottky-Dioden zum Einsatz kommen.

Alternativ ist es vorgesehen, dass eine Auskopplung des Signals vor und hinter dem adaptiven Anpassnetzwerk unter Nutzung von Spulen, Widerständen oder von Kopplern erfolgt.

Dabei gehen die Phaseninformationen des Signals verloren, welche aber mittels zweier Messungen mit unterschiedlichen Konfigurationen des Anpassnetzwerks wieder berechnet wird.

Die der Leistung proportionale Gleichspannung oder der Gleichstrom stellt die Eingangsinformation für eine Kontrolleinheit bzw. entsprechende Messwerte für die Kontrolleinheit dar. Die Kontrolleinheit weist mindestens einen Ausgang zur Ausgabe eines Steuersignals auf. Dieser Ausgang zur Ausgabe eines Steuersignals ist mit einem Steuereingang des adaptiven Anpassnetzwerks verbunden. Das adaptive Anpassnetzwerk kann in seinen Eigenschaften mittels des Steuersignals derart verändert werden, dass eine Anpassung bzw. Veränderung der Impedanz erfolgt. Diese Veränderung der Impedanz wird derart durchgeführt, dass die Impedanz zwischen Hochfrequenzsignalquelle und Antenne angepasst ist bzw. übereinstimmt und somit eine optimale Leistungsübertragung ermöglicht wird.

Das Steuersignal kann durch die Kontrolleinheit beispielsweise unter Verwendung eines Gleichungssystems, in welchem die Impedanzen der Hochfrequenzsignalquelle und der Antenne bestimmt werden, derart erzeugt werde, dass eine optimale Leistungsübertragung erreicht wird. In diesem Fall stimmen also die Impedanzen der Hochfrequenzsignalquelle und der Antenne überein.

Zur Bestimmung der Impedanz der Last und/oder der Signalquelle werden mindestens zwei verschiedene Messungen durchgeführt. Diese Messungen unterscheiden sich in der Konfiguration von mindestens einem der Elemente im adaptiven Anpassnetzwerk. Anhand der bekannten Zustände des adaptiven Anpassnetzwerks kann anhand der gemessenen Gleichspannungen an den Leistungsdetektoren auf die Impedanz der Signalquelle und/oder Last geschlossen werden.

Die Impedanz der Elemente im adaptiven Anpassnetzwerk bzw. die Übertragungsfunktion des adaptiven Anpassnetzwerks muss hierfür nicht zwingend absolut bekannt sein. Es reicht auch die Kenntnis der differentiellen Änderung zwischen den Schaltzuständen aus.

Vorgesehen ist es, dass das adaptive Anpassnetzwerk beispielsweise in einen ersten Schaltzustand versetzt wird. Dies wird durch das Anlegen eines Steuersignals erreicht, welches diesem ersten Schaltzustand entspricht. Ist dieser erste Schaltzustand durch das adaptive Anpassnetzwerk erreicht, erfolgen die Messungen vor und hinter dem adaptiven Anpassnetzwerk, wie weiter oben bereits beschrieben. Die hierbei beispielsweise erzeugten Gleichspannungen werden der Kontrolleinheit zugeführt und von dieser entsprechend verarbeitet. Bei einer derartigen Verarbeitung kann die Kontrolleinheit die anliegenden Gleichspannungen beispielsweise in digitale Messwerte wandeln und zu einem entsprechenden Schaltzustand zugehörig abspeichern.

Nachfolgend kann mittels eines entsprechenden Steuersignals ein zweiter Schaltzustand des adaptiven Anpassnetzwerks eingestellt werden und wiederum entsprechende Messwerte erzeugt, an die Kontrolleinheit übertragen und in dieser zu diesem zweiten Schaltzustand in digitaler Form abgespeichert werden.

Dieser Vorrang der Ermittlung von Messwerten wird beispielsweise mit einem dritten Schaltzustand fortgesetzt und endet, wenn die Messwerte für einen n-ten Schaltzustand ermittelt, übertragen und abgespeichert worden sind.

Die Kontrolleinheit kann nunmehr unter Anwendung üblicher mathematischer Verfahren ermitteln, welcher Schaltzustand des adaptiven Anpassnetzwerks zu einer optimalen Anpassung der Impedanzen zwischen einer Signalquelle und einer Last führt. Dieser Schaltzustand wird nachfolgend durch das bereitstellen des entsprechenden Steuersignals durch die Kontrolleinheit und die Übertragung dieses Steuersignals an das adaptive Anpassnetzwerk im adaptiven Anpassnetzwerk eingestellt.

Eine derartige Anpassung der Impedanz kann beispielsweise bei einem Einschalten eines Gerätes oder einer Baugruppe erfolgen. Alternativ kann eine derartige Anpassung der Impedanz im laufenden Betreib eines Gerätes oder einer Baugruppe in regelmäßigen oder unregelmäßigen Zeitabständen erfolgen. Somit kann eine Anpassung der Impedanz auf sich temporär ändernde Einflüsse beispielsweise auf eine Sendeantenne vorgenommen werden.

Je nach Menge des Vorwissens und der gesuchten Größen sind unterschiedlich viele Messungen mit unterschiedlichen Zuständen des adaptiven Anpassnetzwerks notwendig. Die Anzahl der Messungen bzw. Verfahrensschritte ist jedoch immer bekannt und somit zeitlich deterministisch.

Der Einsatz der Anordnung zur Impedanzanpassung ist in allen ein Signal übertragenden Anordnungen möglich, in welchen eine Anpassung der Impedanzen zwischen einer Signalquelle und einer Last zu einer Optimierung der Signalübertragung führt.

Der Einsatz ist sowohl in Sendeanordnungen wie auch in Sende- und Empfangsanordnungen vorgesehen.

Ein Einsatzgebiet ist beispielsweise der Mobilfunkbereich. Ein anderes Einsatzgebiet ist die Medizintechnik, insbesondere in Bereichen in denen Implantate in Lebewesen zum Einsatz kommen. Derartige Implantate können beispielsweise mit einer außerhalb des Körpers des Lebewesens angeordneten Einheit kommunizieren. Derart können beispielsweise Messdaten aus dem Körper übertragen werden. Alternativ ist es auch möglich, dass die Implantate innerhalb eines Körpers miteinander kommunizieren.

Die zuvor erläuterten Merkmale und Vorteile dieser Erfindung sind nach sorgfältigem Studium der nachfolgenden ausführlichen Beschreibung der hier bevorzugten, nicht einschränkenden Beispielausgestaltungen der Erfindung mit den zugehörigen Zeichnungen besser zu verstehen und zu bewerten, welche zeigen:
- Fig. 1:: eine Anordnung zur Impedanzanpassung aus dem Stand der Technik und
- Fig. 2:: eine erfindungsgemäße Anordnung zur Impedanzanpassung.

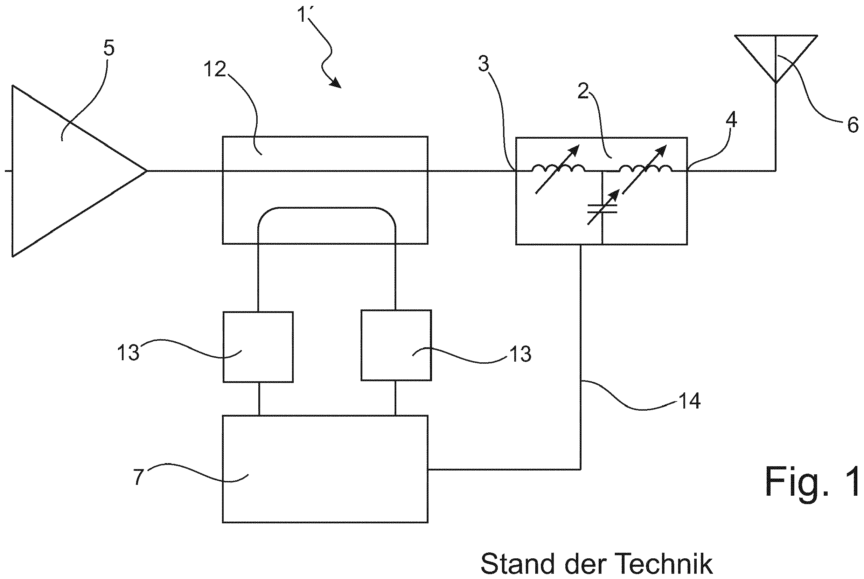

Die Figur 1 zeigt eine Anordnung 1' zur Impedanzanpassung aus dem Stand der Technik. Am Ausgang einer Signalquelle 5 ist in einer Signalübertragungsrichtung ein Richtkoppler 12 und eine adaptives Anpassnetzwerk 2 angeordnet. Hierbei ist das adaptive Anpassnetzwerk 2 mit seinem Eingang 3 mit einem Ausgang des Richtkopplers 12 und mit seinem Ausgang 4 mit einer Last 6 verbunden angeordnet. Im Beispiel der Figur 1 ist die Last 6 eine Antenne. Somit ist das adaptive Anpassnetzwerk 2 mit seinem Eingang 3 zumindest mittelbar mit dem Ausgang der Signalquelle 5 verbunden.

Das adaptives Anpassnetzwerk 2 verfügt über mehrere in einem Längszweig sowie in einem Querzweig angeordnete verstellbare Bauelemente, wie Induktivitäten und Kapazitäten, welche in der Figur 1 nur beispielhaft dargestellt sind. Hierbei ist der Längszweig zwischen dem Eingang 3 und dem Ausgang 4 angeordnet. Die verstellbare Bauelemente können durch ein Steuersignal 14 in Ihren Werten verändert bzw. beeinflusst werden, so dass sich die Eigenschaften des adaptiven Anpassnetzwerks 2 verändern und somit auch die Impedanzen der angeschlossenen Baugruppe, wie beispielsweise eine Ausgangsimpedanz einer Signalquelle 5.

Für die Erzeugung eines derartigen Steuersignals 14 ist eine Kontrolleinheit 7 angeordnet. Diese Kontrolleinheit 7 ist mit zwei Amplituden- und Phasendetektoren 13 verbunden, welche wiederum mit dem Richtkoppler 12 zur Signalmessung verbunden sind. Die von den beiden Amplituden- und Phasendetektoren 13 ermittelten Messwerte werden von der Kontrolleinheit 7 verarbeitet. Im Ergebnis dieser Verarbeitung wird das Steuersignal 14 von der Kontrolleinheit 7 erzeugt und dem adaptiven Anpassnetzwerk 2 zugeführt. Infolge dieses Steuersignals 14 werden die verstellbaren Bauelemente des adaptiven Anpassnetzwerks 2 in einer bestimmten Weise eingestellt und nehmen einen bestimmten Schaltzustand ein.

Aus dem Stand der Technik sind auch Anordnungen 1' zur Impedanzanpassung bekannt, bei welchen die Baugruppen adaptives Anpassnetzwerk 2 und Richtkoppler 12 getauscht sind.

Die Nachteile einer derartigen Anordnung aus dem Stand der Technik liegen darin, dass derartige Amplituden- und Phasendetektoren 13 zur Ermittlung von Messwerten aufwendig sind und einen relativ hohen Leistungsbedarf aufweisen. Außerdem wird eine Baugruppe wie ein Richtkoppler 12 in der Anordnung 1' zur Impedanzmessung benötigt.

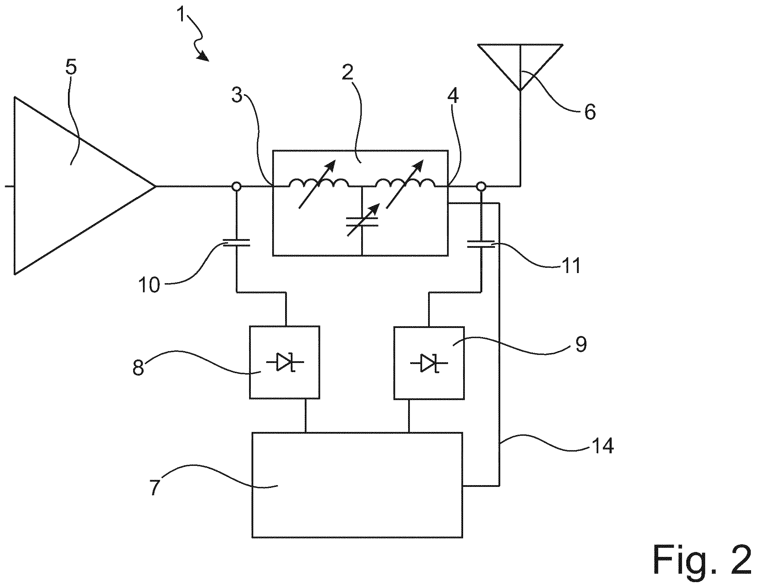

In der Figur 2 ist eine erfindungsgemäße Anordnung zur Impedanzanpassung 1 dargestellt. Die Anordnung zur Impedanzanpassung 1 umfasst ein adaptives Anpassnetzwerk 2, welches mit seinem Eingang 3 mit einer Signalquelle 5 verbunden ist. Das adaptive Anpassnetzwerk 2 ist über seinen Ausgang 4 mit einer Last 6, welche im Beispiel der Figur 2 mindestens eine Antenne ist, verbunden. Außerdem ist das adaptive Anpassnetzwerk 2 mit einer Kontrolleinheit 7 zur Steuerung des adaptiven Anpassnetzwerks 2 mittels eines Steuersignals 14 verbunden.

Gemäß der vorliegenden Erfindung ist die Kontrolleinheit 7 mit ihren Messeingängen mit zwei Leistungsdetektoren 8 und 9 verbunden. Hierbei ist es vorgesehen das ein erster Leistungsdetektor 8 mit dem Eingang 3 des adaptiven Anpassnetzwerks 2 verbunden ist und dass ein zweiter Leistungsdetektor 9 mit dem Ausgang 4 des adaptiven Anpassnetzwerks 2 verbunden ist.

Vorgesehen ist es, jeweils einen Teil des Hochfrequenzsignals am Eingang 3 und am Ausgang 4 des adaptiven Anpassnetzwerks 2 mittels Koppelkondensatoren 10 und 11 aus dem Signalweg auszukoppeln und dass derart ausgekoppelte Signal in eine der Leistung des Hochfrequenzsignals proportionale Gleichspannung oder einen Gleichstrom umzuwandeln. Hierfür ist der erste Leistungsdetektor 8 mit dem Eingang 3 des adaptiven Anpassnetzwerks 2 über den ersten Koppelkondensator 10 und der zweite Leistungsdetektor 9 mit dem Ausgang 4 des adaptiven Anpassnetzwerks 2 über den zweiten Koppelkondensator 11 verbunden.

Die Kontrolleinheit 7 wertet beispielsweise die der Leistung des Hochfrequenzsignals proportionale Gleichspannung an ihren Messeingängen aus und erzeugt in Abhängigkeit dieser Messwerte das Steuersignal 14.

Der erste Leistungsdetektor 8 und der zweite Leistungsdetektor 9 könne beispielsweise vorteilhaft als Schottky-Dioden ausgeführt werden. Derart wird einerseits der für die Leistungsdetektoren 8 und 9 benötigte Bauraum reduziert und andererseits die Kosten für eine Signalmessung reduziert. Außerdem bietet diese Ausführung einen weiteren Vorteil, der darin liegt, dass der Leistungsbedarf gegenüber der Nutzung von Amplituden- und Phasendetektoren signifikant geringer ist.

Die Verwendung des adaptiven Anpassnetzwerks 2 als Serienelement reduziert die Baugröße und Kosten ebenfalls.

Im Gegensatz zu einem Verfahren unter Verwendung des Stehwellenverhältnisses, also einem VSWR-Optimierungsansatz, wird immer das globale Minimum der Anpassverluste gefunden. Das heißt, dass die übertragene Leistung sowie die Effizienz nur im globalen Minimum der Verluste maximal ist.

Es ist zudem eine zeitlich deterministische Anpassung möglich.

Weiterhin kann die Impedanz der Signalquelle 5 bestimmt werden. Außerdem werden nur geringe Anforderungen an bekannte oder zu kalibrierende Messgrößen gestellt.

### LISTE DER BEZUGSZEICHEN

- 1, 1': Anordnung zur Impedanzanpassung
- 2: adaptives Anpassnetzwerk
- 3: Eingang
- 4: Ausgang
- 5: Signalquelle / Hochfrequenzverstärker
- 6: Last / Antenne
- 7: Kontrolleinheit
- 8: erster Leistungsdetektor
- 9: zweiter Leistungsdetektor
- 10: erster Koppelkondensator
- 11: zweiter Koppelkondensator
- 12: Richtkoppler
- 13: Amplituden- und Phasendetektor
- 14: Steuersignal

## Patentansprüche

1. Anordnung (1) zur Impedanzanpassung, welche ein adaptives Anpassnetzwerk (2) umfasst, welches mit einem Eingang (3) mit einer Signalquelle (5) verbunden ist, welches mit einem Ausgang (4) mit einer Antenne (6) verbunden ist und welches mit einer Kontrolleinheit (7) zur Steuerung des adaptiven Anpassnetzwerks (2) verbunden ist, **dadurch gekennzeichnet, dass** ein erster Leistungsdetektor (8) zwischen dem Eingang (3) und der Kontrolleinheit (7) und ein zweiter Leistungsdetektor (9) zwischen dem Ausgang (4) und der Kontrolleinheit (7) angeordnet ist.

2. Anordnung (1) nach Anspruch 1, **dadurch gekennzeichnet, dass** ein erster Kondensator (10) in einer Reihenschaltung mit dem erster Leistungsdetektor (8) zwischen dem Eingang (3) und dem erster Leistungsdetektor (8) angeordnet ist.

3. Anordnung (1) nach Anspruch 1 oder 2, **dadurch gekennzeichnet, dass** ein zweiter Kondensator (11) in einer Reihenschaltung mit dem zweiten Leistungsdetektor (9) zwischen dem Ausgang (4) und dem zweiten Leistungsdetektor (9) angeordnet ist.

4. Anordnung (1) nach einem der Ansprüche 1 bis 3, **dadurch gekennzeichnet, dass** die Kontrolleinheit (7) mit dem adaptiven Anpassnetzwerk (2) zur Übertragung eines Steuersignals (14) verbunden ist.

5. Anordnung (1) nach einem der Ansprüche 1 bis 4, **dadurch gekennzeichnet, dass** der erste Leistungsdetektor (8) und der zweite Leistungsdetektor (9) jeweils eine Schottky-Diode ist.

6. Anordnung (1) nach einem der Ansprüche 1, 4 oder 5 **dadurch gekennzeichnet, dass** eine Spule oder ein Widerstand oder ein Koppler in einer Reihenschaltung mit dem erster Leistungsdetektor (8) zwischen dem Eingang (3) und dem erster Leistungsdetektor (8) und eine weitere Spule oder ein weiterer Widerstand oder ein weiterer Koppler in einer Reihenschaltung mit dem zweiten Leistungsdetektor (9) zwischen dem Ausgang (4) und dem zweiten Leistungsdetektor (9) angeordnet ist.

7. Anordnung (1) nach einem der Ansprüche 1 bis 6, **dadurch gekennzeichnet, dass** die Anordnung (1) in einem Herzschrittmacher oder einer drahtlos Daten übertragenden Kapsel angeordnet ist.
